# EUROPEAN PATENT APPLICATION

(11) **EP 4 481 405 A1**
(43) Date of publication of application: **25.12.2024**
(21) Application number: 23180014.5
(22) Date of filing: 19.06.2023
(51) Int. Cl.: G01R 27/18, G01R 31/00

(54) **SYSTEM AND METHOD FOR STEADY STATE VOLTAGE ESTIMATION IN A BATTERY SYSTEM FOR A VEHICLE**

(71) Applicant: VOLVO TRUCK CORPORATION, 405 08 Göteborg (SE)
(72) Inventor: PALM, Caroline, SE-411 05 GÖTEBORG (SE); BRUNET, Simon, SE-438 33 LANDVETTER (SE)
(74) Representative: Kransell & Wennborg KB

(57) **Abstract**

A computer system (500) comprising processing circuitry (502) configured to: measure an initial voltage V₀ between a pole (106, 108) of a battery (110) in a vehicle and a ground potential of the vehicle; connect a resistance (102, 104) between the pole of the battery and the ground potential (112); measure at least two voltages V(t) over the resistance before the voltage has reached a steady state voltage; fit a predetermined voltage step response model to the at least two measured voltages and the initial voltage; estimate a steady state voltage over the resistance based on the fitted voltage step response model; and determine an isolation resistance (114, 116) based on the estimated steady state voltage.

## Description

### TECHNICAL FIELD

The disclosure relates generally to a high-voltage power system for a vehicle. In particular aspects, the disclosure relates to estimation of a steady state voltage for determination of an isolation resistance for a battery in a vehicle. The disclosure can be applied to any types of heavy-duty vehicles comprising a high-voltage power system, such as trucks, buses, and construction equipment, among other vehicle types. Although the disclosure may be described with respect to a particular vehicle, the disclosure is not restricted to any particular vehicle.

### BACKGROUND

To ensure safety in a high-voltage power system for a vehicle, it is needed to measure the isolation resistance between the high voltage battery and the chassis ground. The isolation resistance measurement shall be conducted by selecting an appropriate measurement method where either an external voltage source or the energy storage system of the vehicle can be used. Such a measurement can also be performed internally by a battery management system. A measure of the isolation resistance can be acquired by inserting a large known test resistor between the battery pole and a ground potential, and by measuring the voltage before and after the test resistor is inserted in order to calculate the isolation resistance. Accordingly, it is desirable to provide a reliable system and method for determining an isolation resistance in a vehicle

### SUMMARY

According to a first aspect of the disclosure, it is provided a computer system comprising processing circuitry configured to: measure initial voltages V₀⁺ and V₀⁻ between a respective positive and negative pole of a battery in a vehicle and a ground potential of the vehicle; connect a resistance between the pole of the battery and the ground potential; measure at least two voltages V(t) over the resistance before the voltage has reached a steady state voltage; fit a predetermined voltage step response model to the at least two measured voltages and the initial voltage of the pole for which the resistance is connected; estimate a steady state voltage over the resistance based on the fitted voltage step response model; and determine an isolation resistance based on the estimated steady state voltage. The first aspect of the disclosure may seek to improve measuring an isolation resistance in a vehicle.

A technical benefit of the first aspect of the disclosure may include that the isolation resistance can be measured quickly without having to wait for the voltage over a resistor to reach a steady state voltage. When connecting the resistance between a pole of the battery and ground, it may take several seconds for the voltage over the capacitance to reach a steady state value, at least in part due to capacitances in the system. Accordingly, it is desirable to be able to determine an isolation resistance more quickly to avoid that a battery is connected to the high voltage bus before it is established that the system is safe. By sampling the voltage over the resistor directly after connecting the resistance, it thus becomes possible to provide a quick initial estimation of the isolation resistance.

Optionally, in some examples, including in at least one preferred example, the processing circuitry is further configured to: determine a quality measure of the fitted voltage step response model; compare the quality measure with a predetermined quality threshold; and discard a fit having a quality measure below the predetermined quality threshold. A technical benefit may include that fits which are erroneous are not used to estimate a steady state voltage, thereby reducing the risk of incorrect isolation resistance estimations. There are many different ways of determining the quality of a fit and any suitable manner can be used to determine if the quality of the fit is sufficient for determining a steady state voltage.

Optionally, in some examples, including in at least one preferred example, the processing circuitry is further configured to perform a second fit of the predetermined voltage step response model, the second fit being fitted to a higher number of measured voltages compared to the first fit. A technical benefit may include that if a first fit is not sufficiently good, a second fit which uses a larger number of voltage samples can be used to achieve a fit fulfilling the quality requirements. A steady state voltage can thereby be estimated in order to determine the isolation resistance.

Optionally, in some examples, including in at least one preferred example, the at least two voltages used to fit the voltage step response model are the first voltage samples acquired after connecting the resistance. A technical benefit may include that the isolation resistance can be determined quickly after connection of the resistance. A sampling rate can be assumed to be significantly faster than the time it takes for the voltage to reach the steady state voltage.

Optionally, in some examples, including in at least one preferred example, the control circuitry is further configured to control a transistor to connect the resistance. A technical benefit may include that the use of a transistor enables fast switching for connecting the resistance.

Optionally, in some examples, including in at least one preferred example, the voltage step response model is described by V(t)=V_{SS}+(V₀-V_{SS})e^{(-t/τ)}. A technical benefit may include that by measuring the initial voltage V₀ and a number of voltage samples V(t), an equation system can be formed where the time constant τ is determined which in turn allows an estimation of the steady state voltage Vss.

Optionally, in some examples, including in at least one preferred example, the processing circuitry is further configured to: determine a first isolation resistance between a positive pole of the battery and ground; and determine a second isolation resistance between a negative pole of the battery and ground. A technical benefit may include that it can be ensured that the isolation resistance is sufficient for both poles of the battery before connecting the battery to a high voltage bus.

Optionally, in some examples, including in at least one preferred example, the processing circuitry is configured to control a voltage measurement unit arranged between a pole of the battery and the ground potential to measure the at least two voltages over the resistance. A technical benefit may include that a voltage measurement integrated in the vehicle power system can be used for convenient determination of the isolation resistance.

Optionally, in some examples, including in at least one preferred example, computer system further comprises a filter configured to filter the at least two measured voltages to reduce noise. A technical benefit may include that the risk of erroneous estimations of the steady state voltage can be reduced.

Optionally, in some examples, including in at least one preferred example, the processing circuitry is configured to: measure an initial voltage V₀⁺ between a positive pole of the battery and ground; measure an initial voltage V₀⁻ between a negative pole of the battery and ground connect a first resistance between the positive pole of the battery and a ground potential; measure a first set of at least two voltages over the first resistance before the voltage has reached a steady state voltage; fit the predetermined voltage step response model to the first set of at least two voltages and the initial voltage; estimate a positive steady state voltage over the first resistance based on the fitted voltage step response model; determine a first isolation resistance based on the estimated positive steady state voltage; disconnect the first resistance; measure an initial voltage V₀⁻ between a negative pole of the battery and ground; measure an initial voltage V₀⁺ between a positive pole of the battery and ground; connect a second resistance between the negative pole of the battery and the ground potential; measure a second set of at least two voltages over the second resistance before the voltage has reached a steady state voltage; fit the predetermined voltage step response model to the second set of at least two voltages and the initial voltage; estimate a negative steady state voltage over the second resistance based on the fitted voltage step response model; and determine a second isolation resistance based on the estimated negative steady state voltage.

According to a second aspect of the disclosure, it is provided a computer-implemented method, comprising: by processing circuitry of a computer system, measuring initial voltages V₀⁺ and V₀⁻ between a respective positive and negative pole of a battery and ground; connecting a resistance between a pole of a battery and a ground potential; measuring at least two voltages V(t) over the resistance before the voltage has reached a steady state voltage; fitting a predetermined voltage step response model to the at least two measured voltages and the initial voltage of the pole for which the resistance is connected; estimating a steady state voltage over the resistance based on the fitted voltage step response model; and determining an isolation resistance based on the estimated steady state voltage.

Technical effects, advantages and features of this second aspect of the present disclosure are largely analogous to those described above in connection with the first aspect of the disclosure.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary circuit diagram of a high-voltage battery system of a vehicle.
**FIG. 2** is an exemplary graph of a voltage step response for determining a steady\-state voltage according to an example.

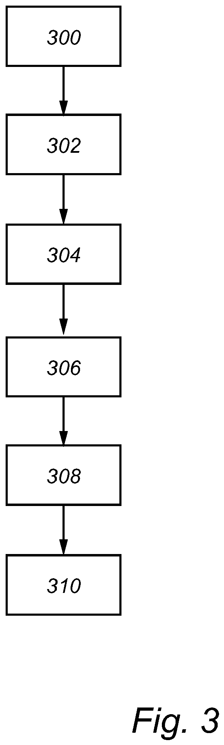

**FIG. 3** is an exemplary flow chart of a method for determining an isolation resistance in a power system of a vehicle according to an example.
**FIG. 4** is an exemplary flow chart of a method for determining an isolation resistance in a power system of a vehicle according to an example.
**FIG. 5** is a schematic diagram of an exemplary computer system for implementing examples disclosed herein, according to an example.
**FIG. 6** is an exemplary circuit diagram of a high-voltage battery system of a vehicle.

### DETAILED DESCRIPTION

The detailed description set forth below provides information and examples of the disclosed technology with sufficient detail to enable those skilled in the art to practice the disclosure. Examples are described in more detail below with reference to the appended drawings.

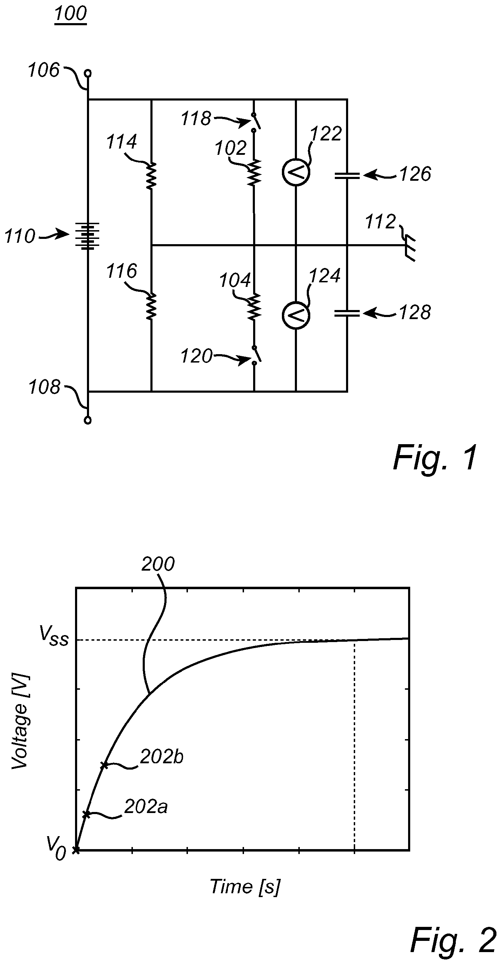

**FIG. 1** is an exemplary circuit diagram schematically illustrating part of a high-voltage system 100 of a vehicle according to an example implementation. The illustrated high-voltage system 100 comprises a battery 110 having a positive pole 106 and a negative pole 108 each connected to a ground potential 112. Between the respective pole and ground is a corresponding resistance 102, 104 connectable by a switch 118, 120. The resistances 102, 104 may be resistors, transistors or any other suitable circuit element providing a sufficiently high resistance. The isolation resistances 114, 116 between the respective battery pole 106, 108 and ground 112 are also illustrated. Moreover, the circuit diagram illustrates capacitances 126, 128 between the respective pole and ground which represent the inherent system capacitances leading to a gradual increase in voltage over the respective resistor 102, 104 when connected. The circuit further comprises two voltage measurement units 122, 124 arranged to measure the voltage over the resistances 102, 104. It would however also be possible to use one voltage measurement unit which is arranged and configured to measure the voltage over both resistances 102, 104 separately.

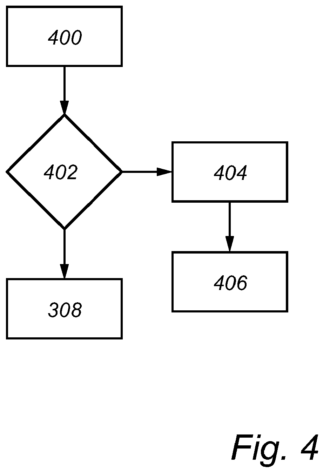

In the following example, a description of a method for determining an isolation resistance will be given with reference to an isolation resistance 114 between the positive pole 106 and ground 112, and the isolation resistance 116 between the negative pole 108 and ground 112 can be determined analogously. The example will be described with further reference to Fig. 2 schematically illustrating voltage over the resistor as a function of time, and Fig. 4 which is a flow chart outlining general steps of a computer implemented method according to an example.

The processing circuitry is first configured to measure 300 initial voltages V₀⁺ and V₀⁻ between the respective positive pole 106 and negative pole 108 of a battery 110 in a vehicle and a ground potential of the vehicle. In Fig. 2, the initial voltage V₀⁺ is illustrated as being equal to zero, but in practice the initial voltage may have a non-zero value. Next, a resistance 102 is connected 302 between the positive pole 106 of the battery and the ground potential 112. The resistance 102 is here illustrated by a resistor 102 arranged between the positive pole 106 of the battery and ground 112 and which is connected 302 by closing a switch 118. The size of the resistor 120 to be connected is dependent on the battery voltage and the size should be selected to ensure that connecting test resistance will not cause a dangerous current, since connecting the resistance will break the battery isolation. In general, the resistance should be significantly larger than 500 times the battery voltage.

Once the switch is connected, at least two voltages V(t) are measured 304 over the resistance 102 before the voltage has reached a steady state voltage Vss. Fig. 2 illustrates two voltage measurements 202a-b taken before the steady state voltage is reached. The sampling rate for measuring the voltages is usually in the millisecond range (such as 10 ms) while the time to reach the steady state voltage is typically several seconds. It should be noted that the time to reach the steady voltage depends on system parameters such as battery voltage and the actual isolation in the system, and a sampling rate is preferably selected to be significantly lower than an expected time to reach the steady state voltage.

Next, the processing circuitry is configured to fit 306 a predetermined voltage step response model to the at least two measured voltages and the initial voltage of the pole for which the resistance is connected, which here is the positive pole 106. The predetermined voltage step response model can be described by a first order system according to V(t)=V_{SS}⁺(V₀-V_{SS})e^{(-t/τ)}. By measuring the start voltage V₀ and at least two more voltages V(t), a system of equations can be set up allowing the steady state voltage Vss to be estimated 308 based on the fitted voltage step response model.

Once the steady state voltage Vss is estimated, the isolation resistance (Rᵢₛₒ) can be determined 310 as Rᵢₛₒ= Rₜₑₛₜ/V_{SS}(1+V_{neg}/Vₚₒₛ)(Vₚₒₛ-V_{SS}) where Rₜₑₛₜ is the connected test resistance 102.

In this example when the switch 118 on the positive pole 106 is closed and the voltage is measured by the corresponding voltage measurement unit 122 on the positive pole 106, the determined voltage values are used to calculate the isolation resistance 116 on the negative side 108. Accordingly, Rᵢₛₒ is here the isolation resistance 116 between negative pole 108 and ground 112, Rₜₑₛₜ is the positive side test resistance 102, Vss the positive pole 106 steady state voltage measured by the voltage measurement unit 122, Vₚₒₛ is the initial voltage V₀⁺ of the positive pole 106 measured by the voltage measurement unit 122 on the positive pole, and V_{neg} is the initial voltage V₀⁻ of the negative pole 108 measured by the voltage measurement unit 124 on the negative pole 108.

The isolation resistance 114 for the positive pole 106 can then be determined in an analogous manner by measuring over the resistance 104 on the negative side 106.

Accordingly, the described method and system provides a quick initial estimate of an isolation resistance to ensure system safety before connecting the battery to a high-voltage bus. Since the voltage takes time to reach its steady state value, the measurement may not be finalized before the battery is connected to the high voltage bus which could impose a safety risk or risk of disconnecting battery again after external measurement.

Fig. 4 schematically illustrates a method where the processing circuitry is configured to determine 400 a quality measure of the fitted voltage step response model compare 402 the quality measure with a predetermined quality threshold; and discard 404 a fit having a quality measure below the predetermined quality threshold. A type of quality measure for a fit known by the skilled person can be used to determine a quality of the fit, and the threshold can for example be set based on empirical testing to ensure that bad fits do not lead to erroneous estimations of the steady state voltage and in turn to the isolation resistance.

If it is determined that quality of the fit is below the quality threshold, a second fit can be performed 406 where the model is fitted to a higher number of measured voltages. If a first fit or if subsequent fits fail to fulfill the quality requirement of the fit, it would also be possible to wait for an actual steady state voltage before the isolation resistance is determined.

Moreover, if it is known that the measured voltage signal is noisy and if fitting is difficult or often fails, filtering of the measured voltages maybe employed, for example by low-pass filtering the voltage signal or by removing outliers. Removal of outliers can for example be based on a difference between a measured sample and one or more previous samples. Filtering and removal of outliers would most likely require more than two measurement points, but with a fast measurement device having a high sampling rate, it would still be possible to achieve a quick estimate of the steady state voltage.

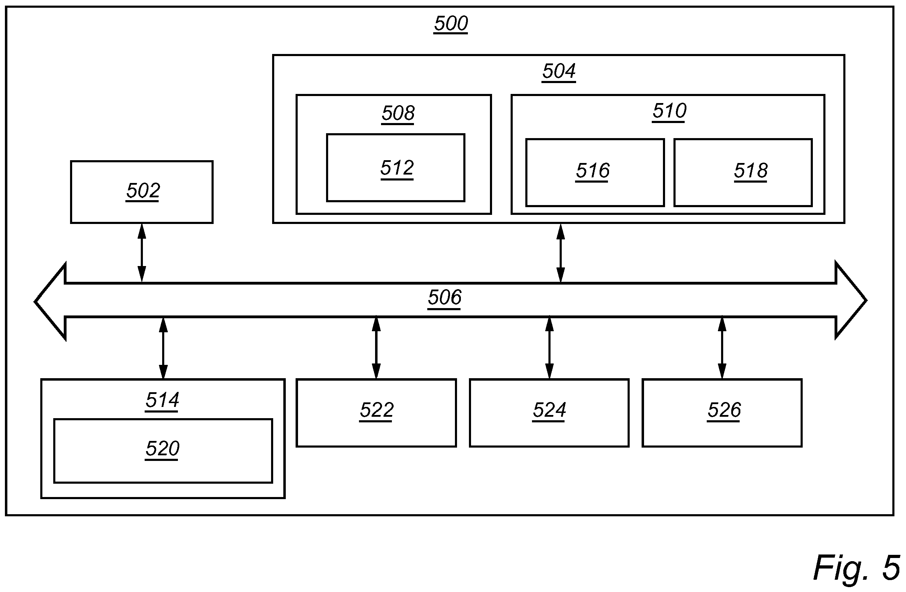

FIG. 5 is a schematic diagram of a computer system 500 for implementing examples disclosed herein. The computer system 500 is adapted to execute instructions from a computer-readable medium to perform these and/or any of the functions or processing described herein. The computer system 500 may be connected (e.g., networked) to other machines in a LAN, an intranet, an extranet, or the Internet. While only a single device is illustrated, the computer system 500 may include any collection of devices that individually or j ointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or j ointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include processing circuitry 502 (e.g., processing circuitry including one or more processor devices or control units), a memory 504, and a system bus 506. The computer system 500 may include at least one computing device having the processing circuitry 502. The system bus 506 provides an interface for system components including, but not limited to, the memory 504 and the processing circuitry 502. The processing circuitry 502 may include any number of hardware components for conducting data or signal processing or for executing computer code stored in memory 504. The processing circuitry 502 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 502 may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processing circuitry 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with processing circuitry 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program 520 stored on a transitory or non-transitory computer-usable or computer-readable storage medium (e.g., single medium or multiple media), such as the storage device 514, which includes complex programming instructions (e.g., complex computer-readable program code) to cause the processing circuitry 502 to carry out actions described herein. Thus, the computer-readable program code of the computer program 520 can comprise software instructions for implementing the functionality of the examples described herein when executed by the processing circuitry 502. In some examples, the storage device 514 may be a computer program product (e.g., readable storage medium) storing the computer program 520 thereon, where at least a portion of a computer program 520 may be loadable (e.g., into a processor) for implementing the functionality of the examples described herein when executed by the processing circuitry 502. The processing circuitry 502 may serve as a controller or control system for the computer system 500 that is to implement the functionality described herein.

The computer system 500 may include an input device interface 522 configured to receive input and selections to be communicated to the computer system 500 when executing instructions, such as from a keyboard, mouse, touch-sensitive surface, etc. Such input devices may be connected to the processing circuitry 502 through the input device interface 522 coupled to the system bus 506 but can be connected through other interfaces, such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may include a communications interface 526 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

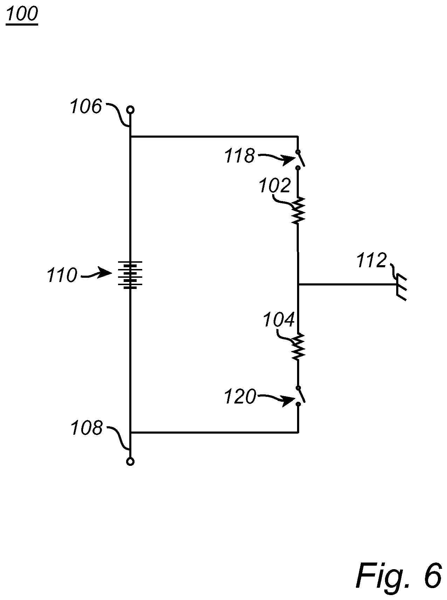

Fig. 6 is a schematic circuit schematic representing circuitry 100 in a vehicle where processing circuitry of a computer system is configured to: measure initial voltages V₀⁺ and V₀⁻ between a respective positive and negative pole 106, 108 of a battery 110 in a vehicle and a ground potential 112 of the vehicle; connect a respective resistance 102, 104 between the pole 102, 104 of the battery 110 and the ground potential 112; measure at least two voltages V(t) over the resistance 102, 104 before the voltage has reached a steady state voltage; fit a predetermined voltage step response model to the at least two measured voltages and the initial voltage of the pole for which the resistance is connected; estimate a steady state voltage over the resistance based on the fitted voltage step response model; and determine an isolation resistance 114, 116 based on the estimated steady state voltage.

Example 1: A computer system comprising processing circuitry configured to: measure initial voltages V₀⁺ and V₀⁻ between a respective positive and negative pole of a battery in a vehicle and a ground potential of the vehicle; connect a resistance between the pole of the battery and the ground potential; measure at least two voltages V(t) over the resistance before the voltage has reached a steady state voltage; fit a predetermined voltage step response model to the at least two measured voltages and the initial voltage of the pole for which the resistance is connected; estimate a steady state voltage over the resistance based on the fitted voltage step response model; and determine an isolation resistance based on the estimated steady state voltage.

Example 2. The computer system according to example 1, wherein the processing circuitry is further configured to: determine a quality measure of the fitted voltage step response model; compare the quality measure with a predetermined quality threshold; and discard a fit having a quality measure below the predetermined quality threshold.

Example 3. The computer system according to example 2, wherein the processing circuitry is further configured to: perform a second fit of the predetermined voltage step response model, the second fit being fitted to a higher number of measured voltages compared to the first fit.

Example 4. The computer system according to any one of the preceding examples, where the at least two voltages used to fit the voltage step response model are the first voltage samples acquired after connecting the resistance.

Example 5. The computer system according to any one of the preceding examples, wherein the control circuitry is further configured to control a transistor to connect the resistance.

Example 6. The computer system according to any one of the preceding examples, wherein the voltage step response model is described by V(t)=V_{SS}⁺(V₀-V_{SS})e^{(-t/τ)}.

Example 7. The computer system according to any one of the preceding examples, wherein the processing circuitry is further configured to: determine a first isolation resistance between a positive pole of the battery and ground; and determine a second isolation resistance between a negative pole of the battery and ground.

Example 8. The computer system according to any one of the preceding examples, wherein the processing circuitry is configured to control a voltage measurement unit arranged between a pole of the battery and the ground potential to measure the at least two voltages over the resistance.

Example 9. The computer system according to any one of the preceding examples, further comprising a filter configured to filter the at least two measured voltages to reduce noise.

Example 10. The computer system of example 9, wherein the filter is configured to remove outliers based on a difference between a measured sample and one or more previous samples.

Example 11. The computer system of any of the preceding examples, wherein the processing circuitry is configured to: measure an initial voltage V0⁺ between a positive pole of the battery and ground; measure an initial voltage V₀⁻ between a negative pole of the battery and ground; connect a first resistance (102) between the positive pole (106) of the battery (104) and a ground potential (110); measure a first set of at least two voltages over the first resistance before the voltage has reached a steady state voltage; fit the predetermined voltage step response model to the first set of at least two voltages to; estimate a positive steady state voltage over the first resistance based on the fitted voltage step response model; determine a first isolation resistance based on the estimated positive steady state voltage; disconnect the first resistance; measure an initial voltage V0⁺ between a positive pole of the battery and ground; measure an initial voltage V0⁻ between a negative pole (108) of the battery and ground; connect a second resistance (104) between the negative pole of the battery and the ground potential; measure a second set of at least two voltages over the second resistance before the voltage has reached a steady state voltage; fit the predetermined voltage step response model to the second set of at least two voltages to; estimate a negative steady state voltage over the second resistance based on the fitted voltage step response model; and determine a second isolation resistance based on the estimated negative steady state voltage.

Example 12. A vehicle comprising the computer system of any of examples 1-11.

Example 13. A computer-implemented method, comprising: by processing circuitry of a computer system, measuring an initial voltage V₀ between a pole of a battery and ground; connecting a resistance between a pole of a battery and a ground potential; measuring at least two voltages V(t) over the resistance before the voltage has reached a steady state voltage; fitting a predetermined voltage step response model to the at least two measured voltages; estimating a steady state voltage over the resistance based on the fitted voltage step response model; and determining an isolation resistance based on the estimated steady state voltage.

Example 14. The computer implemented method according to example 13, further comprising: by the processing circuitry, determining a quality measure of the fitted voltage step response model; comparing the quality measure with a predetermined quality threshold; and discarding a fit having a quality measure below the predetermined quality threshold.

Example 15. The method according to example 14, further comprising: by the processing circuitry, performing (406) a second fit of the predetermined voltage step response model, the second fit being fitted to a higher number of measured voltages compared to the first fit.

Example 16. The method according to any one of examples 13 to 15, further comprising: by the processing circuitry, determining a first isolation resistance between a positive pole of the battery and ground; and determining a second isolation resistance between a negative pole of the battery and ground.

Example 17. The method according to any one of examples 13 to 15, further comprising controlling a voltage measurement unit arranged between a pole of the battery and the ground potential to measure the at least two voltages over the resistance.

Example 18. The method according to any one of examples 13 to 17, further comprising filtering the at least two measured voltages to reduce noise.

Example 19. A computer program product comprising program code for performing, when executed by the processing circuitry, the method of any of examples 13 to 18.

Example 20. A non-transitory computer-readable storage medium comprising instructions, which when executed by the processing circuitry, cause the processing circuitry to perform the method of any of examples 13 to 18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended examples. In the drawings and specification, there have been disclosed aspects for purposes of illustration only and not for purposes of limitation, the scope of the disclosure being set forth in the following examples.

## Claims

1. A computer system (500) comprising processing circuitry (502) configured to:
measure initial voltages V₀⁺ and V₀⁻ between a respective positive and negative pole (106, 108) of a battery (110) in a vehicle and a ground potential of the vehicle;
connect a resistance (102, 104) between one pole of the battery and the ground potential (112);
measure at least two voltages V(t) over the resistance before the voltage has reached a steady state voltage;
fit a predetermined voltage step response model to the at least two measured voltages and the initial voltage of the pole for which the resistance is connected;
estimate a steady state voltage over the resistance based on the fitted voltage step response model; and
determine an isolation resistance (114, 116) based on the estimated steady state voltage.

2. The computer system according to claim 1, wherein the processing circuitry is further configured to:
determine a quality measure of the fitted voltage step response model;
compare the quality measure with a predetermined quality threshold; and
discard a fit having a quality measure below the predetermined quality threshold.

3. The computer system according to claim 2, wherein the processing circuitry is further configured to:
perform a second fit of the predetermined voltage step response model, the second fit being fitted to a higher number of measured voltages compared to the first fit.

4. The computer system according to any one of the preceding claims, where the at least two voltages used to fit the voltage step response model are the first voltage samples acquired after connecting the resistance.

5. The computer system according to any one of the preceding claims, wherein the control circuitry is further configured to control a transistor to connect the resistance.

6. The computer system according to any one of the preceding claims, wherein the voltage step response model is described by V(t)=V_{SS}⁺(V₀-V_{SS})e^{(-t/τ)}.

7. The computer system according to any one of the preceding claims, wherein the processing circuitry is further configured to:
determine a first isolation resistance (114) between a positive pole of the battery and ground; and
determine a second isolation resistance (116) between a negative pole of the battery and ground.

8. The computer system according to any one of the preceding claims, wherein the processing circuitry is configured to control a voltage measurement unit (122, 124) arranged between a pole of the battery and the ground potential to measure the at least two voltages over the resistance.

9. The computer system according to any one of the preceding claims, further comprising a filter configured to filter the at least two measured voltages to reduce noise.

10. The computer system of claim 9, wherein the filter is configured to remove outliers based on a difference between a measured sample and one or more previous samples

11. The computer system of any of the preceding claims, wherein the processing circuitry is configured to:
measure an initial voltage V₀⁺ between a positive pole of the battery and ground;
measure an initial voltage V₀⁻ between a negative pole of the battery and ground;
connect a first resistance (102) between the positive pole (106) of the battery (104) and a ground potential (110);
measure a first set of at least two voltages over the first resistance before the voltage has reached a steady state voltage;
fit the predetermined voltage step response model to the first set of at least two voltages and the initial voltage V₀+;
estimate a positive steady state voltage over the first resistance based on the fitted voltage step response model;
determine a first isolation resistance based on the estimated positive steady state voltage;
disconnect the first resistance;
measure an initial voltage V₀⁻ between a negative pole (108) of the battery and ground;
measure an initial voltage V₀⁺ between a positive pole of the battery and ground;
connect a second resistance (104) between the negative pole of the battery and the ground potential;
measure a second set of at least two voltages over the second resistance before the voltage has reached a steady state voltage;
fit the predetermined voltage step response model to the second set of at least two voltages and the initial voltage V₀⁻;
estimate a negative steady state voltage over the second resistance based on the fitted voltage step response model; and
determine a second isolation resistance based on the estimated negative steady state voltage.

12. A vehicle comprising the computer system of any of claims 1-11.

13. A computer-implemented method, comprising:
by processing circuitry of a computer system, measuring (300) initial voltages V₀⁺ and V₀⁻ between a respective positive and negative pole of a battery and ground;
connecting (302) a resistance (102, 104) between a pole (106, 108) of a battery (110) and a ground potential (112);
measuring (304) at least two voltages V(t) over the resistance before the voltage has reached a steady state voltage;
fitting (306) a predetermined voltage step response model to the at least two measured voltages and the initial voltage of the pole for which the resistance is connected;
estimating (308) a steady state voltage over the resistance based on the fitted voltage step response model; and
determining (310) an isolation resistance (114, 116) based on the estimated steady state voltage.

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.
